# EUROPEAN PATENT APPLICATION

(11) **EP 4 664 238 A1**
(43) Date of publication of application: **17.12.2025**
(21) Application number: 24841926.9
(22) Date of filing: 26.02.2024
(51) Int. Cl.: G06F 1/16

(54) **ROTATING SHAFT MECHANISM AND ELECTRONIC DEVICE**

(30) Priority: 17.07.2023 CN 202310871855
(71) Applicant: Honor Device Co., Ltd., Shenzhen, Guangdong 518040 (CN)
(72) Inventor: LIU, Xiaodong, Shenzhen, Guangdong 518040 (CN); DONG, Shaohong, Shenzhen, Guangdong 518040 (CN); CHEN, Ruihao, Shenzhen, Guangdong 518040 (CN)
(74) Representative: Epping - Hermann - Fischer
(86) International application number: PCT/CN2024/078564
(87) International publication number: WO 2025/015920

(57) **Abstract**

This application discloses a rotating shaft mechanism and an electronic device, and belongs to the field of electronic device technologies. The rotating shaft mechanism includes a base, a door panel, a connecting member, and a first swing arm. The connecting member is rotatably connected to the door panel. When the first swing arm rotates from a folded position to an unfolded position relative to the base, the first swing arm slides from a first position to a second position relative to the connecting member. There is a first limiting structure between the first swing arm and the door panel. When the first swing arm is at the folded position, the first limiting structure is capable of limiting sliding of the first swing arm in a specified direction relative to the connecting member. The specified direction is a direction from the first position to the second position. The electronic device includes a flexible display screen, a housing, and the rotating shaft mechanism. A first sub-housing and a second sub-housing are separately connected to the rotating shaft mechanism. In this application, motion braking on the first swing arm can be implemented, so that a possibility that the first swing arm squeezes, in the case of a drop, space for accommodating the display screen is reduced, thereby ensuring structural integrity and functional stability of the display screen.

## Description

This application claims priority to Chinese Patent Application No. 202310871855.0, filed with the China National Intellectual Property Administration on July 17, 2023 and entitled "ROTATING SHAFT MECHANISM AND ELECTRONIC DEVICE", which is incorporated herein by reference in its entirety.

### TECHNICAL FIELD

This application relates to the field of electronic device technologies, and in particular, to a rotating shaft mechanism and an electronic device.

### BACKGROUND

With development of technologies and usage requirements, a portability requirement of an electronic device (for example, a mobile phone or a tablet computer) is gradually improved. A new form of electronic device, namely, a foldable electronic device, emerges. A display screen of the foldable electronic device mainly has an unfolded state and a folded state. To implement conversion between unfolding and folding, the foldable electronic device implements the function by using a rotating shaft mechanism. The rotating shaft mechanism includes a base, a swing arm, and a connecting block. One end of the swing arm is rotatably connected to the base, and the other end of the swing arm is slidably connected to the connecting block, so that the swing arm can switch between an unfolded position and a folded position. However, during use, the foldable electronic device in the folded state may drop accidentally, and during the drop, the base may first come into contact with the ground, and the base causes the swing arm to slide relative to the connecting block. Consequently, the swing arm squeezes space for accommodating a display screen, resulting in an inner screen failure of the display screen.

### SUMMARY

This application provides a rotating shaft mechanism and an electronic device, to resolve, to some extent, a technical problem that a swing arm slides relative to a connecting block in the case of a drop, and consequently, the swing arm squeezes space for accommodating a display screen, resulting an inner screen failure of the display screen.

The technical solutions are as follows:
A first aspect of this application provides a rotating shaft mechanism, including a base, a door panel, a connecting member, and a first swing arm, where
the connecting member is rotatably connected to the door panel; and
the first swing arm is slidably connected to the connecting member, the first swing arm is further rotatably connected to the base, and when the first swing arm rotates from a folded position to an unfolded position relative to the base, the first swing arm slides from a first position to a second position relative to the connecting member, where
there is a first limiting structure between the first swing arm and the door panel, and when the first swing arm is at the folded position, the first limiting structure is capable of limiting sliding of the first swing arm in a specified direction relative to the connecting member, where the specified direction is a direction from the first position to the second position.

According to the foregoing solution, when the first swing arm is at the folded position, in the case of a drop, disposing the first limiting structure between the first swing arm and the door panel can limit sliding of the first swing arm relative to the connecting member, which implements motion braking on the first swing arm, so that a possibility that the first swing arm squeezes, in the case of a drop, space for accommodating a display screen is reduced, thereby ensuring structural integrity and functional stability of the display screen.

In some implementations, the first limiting structure includes a first abutment surface disposed on the door panel and a second abutment surface disposed on the first swing arm, and the first abutment surface is capable of being in contact with the second abutment surface.

According to the foregoing solution, the first abutment surface and the second abutment surface are respectively disposed on the door panel and the first swing arm. When the first swing arm is at the folded position, the first abutment surface can abut against the second abutment surface during a drop, so that the first swing arm is restricted from continuing moving relative to the connecting member, thereby helping ensure structural and functional integrity of the display screen. In addition, using a structure in which the first abutment surface abuts against the second abutment surface facilitates manufacturing, and the structure is relatively simple and effective.

In some implementations, there are a plurality of first abutment surfaces, and the plurality of first abutment surfaces are distributed in a stepped manner;
there are a plurality of second abutment surfaces, and the plurality of second abutment surfaces are distributed in a stepped manner; and
the plurality of first abutment surfaces are in a one-to-one correspondence with the plurality of second abutment surfaces.

According to the foregoing solution, the plurality of stepped first abutment surfaces are in a one-to-one correspondence with the plurality of stepped second abutment surfaces. In this way, after first abutment surfaces at different positions abut against corresponding second abutment surfaces, multi-position abutment is implemented, so that effectiveness of a function of a limiting structure is ensured, thereby improving limiting and motion stop performance of the door panel for the first swing arm.

In some implementations, the door panel has a first protruding structure, and an end surface of the first protruding structure forms a first abutment surface;
the first swing arm has a first recessed groove, and a groove wall of the first recessed groove forms a second abutment surface; and
when the first swing arm is at the folded position, the first protruding structure extends into the first recessed groove, so that the first abutment surface is capable of being in contact with the second abutment surface.

According to the foregoing solution, the first protruding structure is disposed on the door panel, and the first recessed groove is disposed on the first swing arm. In this way, after the first protruding structure is inserted into the first recessed groove, a corresponding first abutment surface and second abutment surface are formed at a position at which the first protruding structure abuts against the first recessed groove. In addition, fitting between the first protruding structure and the first recessed groove can optimize a fitting relationship between the door panel and the first swing arm. The first abutment surface can be in contact with the second abutment surface only when the first swing arm is at the folded position. In this way, motion limitation of the door panel for the first swing arm can be facilitated in the case of a drop, so that structural integrity and functional stability of the display screen is ensured.

In some implementations, the first swing arm includes a first subpart and a second subpart, the first subpart is connected to the second subpart, a stepped surface is formed at a joint of the first subpart and the second subpart, the stepped surface forms another second abutment surface, and a surface at an edge of the door panel forms another first abutment surface; and the first recessed groove is located on the second subpart.

According to the foregoing solution, the first subpart of the first swing arm is connected to the base, and the second subpart is mainly configured to slidably connect to the connecting member. The stepped surface is formed at the joint of the first subpart and the second subpart, the stepped surface may form the another second abutment surface, and the surface at the edge of the door panel forms the another first abutment surface. In this way, after the stepped surface abuts against the surface at the edge of the door panel, abutment between the first abutment surface and the second abutment surface is implemented. In this way, in the case of a drop, the first protruding structure is inserted into the first recessed groove, and the stepped surface abuts against the surface at the edge of the door panel, so that two first abutment surfaces abut against two second abutment surfaces in a one-to-one correspondence, thereby further ensuring structural integrity and functional stability of the display screen.

In some implementations, there is a second limiting structure between the first swing arm and the connecting member, and when the first swing arm is at the unfolded position, the second limiting structure is capable of limiting sliding of the first swing arm in the specified direction relative to the connecting member.

According to the foregoing solution, the following can be implemented: The first swing arm does not excessively rotate relative to the base, and the first swing arm does not excessively slide relative to the connecting member. Therefore, an unfolding degree of the first swing arm is limited, and excessive unfolding can be avoided.

In some implementations, the second limiting structure includes a third abutment surface disposed on the connecting member and the second abutment surface formed by the groove wall of the first recessed groove; and
the third abutment surface is configured to be in contact with the second abutment surface.

According to the foregoing solution, the third abutment surface abuts against the second abutment surface, to limit an angle of rotation of the first swing arm relative to the base. To be specific, in an unfolding process of the first swing arm, the unfolding degree of the first swing arm is limited, and excessive unfolding can be avoided. In this way, the first abutment surface and the third abutment surface can respectively abut against the second abutment surface in different states, so that limitation in a folded state and an unfolded state is ingeniously implemented.

In some implementations, the connecting member has a second protruding structure, and an end surface of the second protruding structure forms the third abutment surface; and
when the first swing arm is at the unfolded position, the second protruding structure extends into the first recessed groove, so that the third abutment surface is capable of being in contact with the second abutment surface.

According to the foregoing solution, the third abutment surface is formed at a position at which the second protruding structure abuts against the first recessed groove when the second protruding structure is inserted into the first recessed groove. In this way, the first protruding structure and the second protruding structure are respectively inserted into the first recessed groove when the first swing arm is located at different positions (that is, the folded position and the unfolded position), so that limitation on the first swing arm relative to the connecting member is implemented.

In some implementations, the connecting member includes a body part and a limiting clamp arm, the body part has a first sliding groove, two opposite sidewalls of the first sliding groove are separately connected to the limiting clamp arm, and the limiting clamp arm is configured to limit the first swing arm within the first sliding groove;
the door panel has an avoidance groove, and the avoidance groove is configured to accommodate the limiting clamp arm;
a partial structure of the first swing arm is located between the body part and the door panel; and
the first protruding structure is located in the avoidance groove, and the second protruding structure is located in the first sliding groove.

According to the foregoing solution, the first swing arm is limited within the first sliding groove by using the limiting clamp arm, so that the first swing arm slides relative to the connecting member. However, the disposed avoidance groove accommodates the limiting clamp arm, to implement avoidance of motion between the first swing arm and the connecting member, and facilitate insertion of the first protruding structure into the first recessed groove and insertion of the second protruding structure into the first recessed groove.

In some implementations, the first sliding groove is a linear sliding groove, and is configured to enable the first swing arm to linearly move relative to the connecting member; or
the first sliding groove is a curved-surface sliding groove, and is configured to enable the first swing arm to swing relative to the connecting member.

According to the foregoing solution, different types of first sliding grooves may be used based on different types of rotating shaft mechanisms. In addition, in a same rotating shaft mechanism, when there are a plurality of first swing arms, different types of sliding grooves may be adapted to different first swing arms, to be specific, some first sliding grooves are linear sliding grooves, and some other first sliding grooves are curved-surface sliding grooves.

In some implementations, the rotating shaft mechanism further includes a second swing arm, the second swing arm is rotatably connected to the base, and the second swing arm is rotatably connected to the connecting member.

According to the foregoing solution, after the second swing arm is separately rotatably connected to the base and the connecting member, when the second swing arm is at a folded position and an unfolded position relative to the base, a distance between an axis of the rotatable connection between the second swing arm and the base and an axis of the rotatable connection between the second swing arm and the connecting member can remain unchanged. In this case, it is ensured that the first swing arm can slide relative to the connecting member.

In some implementations, there is a lower-pair connection between the door panel and the connecting member, and the second swing arm is configured to drive the door panel to move. According to the foregoing solution, when the rotating shaft mechanism switches between the folded state and the unfolded state, the door panel is jointly driven by the connecting member and the second swing arm. In addition, when the rotating shaft mechanism switches between the folded state and the unfolded state, the first swing arm does not participate in driving the door panel, in other words, there is no motion association in which the door panel directly fits with the first swing arm. In this way, after the first limiting structure is designed between the door panel and the first swing arm, in the case of a drop, the base is first subject to a collision force, and then the force is sequentially transferred to the first swing arm, the door panel, the connecting member, and a housing of an electronic device, to resist relative sliding between the first swing arm and a connecting block during the drop, thereby reducing a failure risk of the display screen.

In some implementations, there is a higher-pair connection between the second swing arm and the door panel, the second swing arm has a first through hole, the door panel has a first connection lug, the first connection lug has an arc-shaped through hole, the first connection lug is inserted into the first through hole, a first pin shaft passes through the arc-shaped through hole, and the first pin shaft further passes through the second swing arm and is disposed on the second swing arm.

According to the foregoing solution, driving between the second swing arm and the door panel is facilitated, and the door panel can rotate relative to the connecting member.

In some implementations, a first arc surface structure is disposed on the door panel, a second arc surface structure is disposed on the connecting member, and the first arc surface structure fits with the second arc surface structure.

According to the foregoing solution, the first arc surface structure fits with the second arc surface structure, so that the door panel can rotate relative to the connecting member.

In some implementations, the rotating shaft mechanism further includes a third swing arm, the third swing arm is rotatably connected to the base, and the third swing arm is movably connected to the door panel.

According to the foregoing solution, the door panel may be jointly driven by the third swing arm and the connecting member. The second swing arm is not responsible for driving the door panel, in other words, the second swing arm is separately rotatably connected only to the base and the connecting member.

In some implementations, the rotating shaft mechanism further includes a flexible support plate, and the flexible support plate is configured to support a flexible display screen of an electronic device; and the flexible support plate is fixedly connected to the door panel.

According to the foregoing solution, the flexible support plate can better implement support for the flexible display screen.

A second aspect of this application provides an electronic device, including a flexible display screen, a housing, and the rotating shaft mechanism, where the housing includes a first sub-housing and a second sub-housing, the first sub-housing and the second sub-housing are separately connected to the rotating shaft mechanism, and the first sub-housing and the second sub-housing are capable of rotating relative to each other by using the rotating shaft mechanism; and the flexible display screen is separately connected to the first sub-housing and the second sub-housing.

According to the foregoing solution, after the rotating shaft mechanism is applied to the electronic device, when the first swing arm is at a folded position, in the case of a drop, disposing a first limiting structure between a first swing arm and a door panel can limit sliding of the first swing arm relative to a connecting member, which implements motion braking on the first swing arm, so that a possibility that the first swing arm squeezes, in the case of a drop, space for accommodating the display screen is reduced, thereby ensuring structural integrity and functional stability of the display screen.

In some implementations, the door panel is fixedly connected to the flexible display screen; or
the door panel is capable of moving relative to the flexible display screen. According to the foregoing solution, it can be determined, based on a case, whether the flexible display screen is fastened to the door panel.

### BRIEF DESCRIPTION OF DRAWINGS

FIG. 1 is a schematic diagram of a structure of an electronic device in a folded state according to an embodiment of this application;
FIG. 2 is a schematic diagram of a structure of an electronic device in a half-unfolded state according to an embodiment of this application;
FIG. 3 is a schematic diagram of a structure of an electronic device in an unfolded state according to an embodiment of this application;
FIG. 4 is a schematic diagram of an exploded structure of the electronic device shown in FIG. 3;
FIG. 5 is a cross-sectional view of a rotating shaft mechanism at a position at which a swing arm is in sliding fit with a connecting member in a related technology;
FIG. 6 is a cross-sectional view of a rotating shaft mechanism at a higher-pair connection of a swing arm and a door panel;
FIG. 7 is a partial exploded view of a partial rotating shaft mechanism according to an embodiment of this application;
FIG. 8 is a partial exploded view of a partial rotating shaft mechanism from another angle according to an embodiment of this application;
FIG. 9 is a cross-sectional view of a rotating shaft mechanism in a folded state at a position at which a first swing arm fits with a first sliding groove according to an embodiment of this application;
FIG. 10 is a cross-sectional view of a rotating shaft mechanism in an unfolded state at a position at which a first swing arm fits with a first sliding groove according to an embodiment of this application;
FIG. 11 is a cross-sectional view of a rotating shaft mechanism in a folded state at a first recessed groove of a first swing arm according to an embodiment of this application;
FIG. 12 is a cross-sectional view of a rotating shaft mechanism in an unfolded state at a first recessed groove of a first swing arm according to an embodiment of this application;
FIG. 13 is a schematic diagram of a partial structure of a door panel according to an embodiment of this application.
FIG. 14 is a schematic diagram of a structure of a first swing arm according to an embodiment of this application;
FIG. 15 is a schematic diagram of a structure of a first swing arm from another angle according to an embodiment of this application;
FIG. 16 is a schematic diagram of a partial structure of a connecting member according to an embodiment of this application;
FIG. 17 is a schematic diagram of a partial structure of a connecting member from another angle according to an embodiment of this application;
FIG. 18 is a cross-sectional view of a rotating shaft mechanism in a folded state at a joint of a second swing arm and a door panel according to an embodiment of this application;
FIG. 19 is a cross-sectional view of a rotating shaft mechanism in an unfolded state at a joint of a second swing arm and a door panel according to an embodiment of this application;
FIG. 20 is a schematic diagram of a structure of a second swing arm according to an embodiment of this application;
FIG. 21 is a schematic diagram of a structure of a second swing arm from another angle according to an embodiment of this application;
FIG. 22 is a schematic diagram (exploded view) of a partial structure of a rotating shaft mechanism having a third swing arm according to an embodiment of this application;
FIG. 23 is another cross-sectional view of a rotating shaft mechanism in a folded state at a first recessed groove of a first swing arm according to an embodiment of this application; and
FIG. 24 is another cross-sectional view of a rotating shaft mechanism in an unfolded state at a first recessed groove of a first swing arm according to an embodiment of this application.

Meanings represented by reference numerals are respectively as follows:
10. first base; 11. swing arm; 12. first door panel; 13. connecting block;
101. first sub-housing; 102. second sub-housing;
200. display screen; 201. first portion; 202. second portion; 203. foldable portion;
300. rotating shaft mechanism; 301. base; 302. door panel; 303. connecting member; 304. first swing arm; 305. second swing arm; 306. first abutment surface; 307. second abutment surface; 308. first protruding structure; 309. first recessed groove; 310. first subpart; 311. second subpart; 312. curved surface structure; 313. limiting plate structure; 314. third abutment surface; 315. second protruding structure; 316. body part; 317. limiting clamp arm; 318. first sliding groove; 319. avoidance groove; 320. groove bottom; 321. circular arc surface; 322. first arc surface structure; 323. second arc surface structure; 324. first through hole; 325. first connection lug; 326. arc-shaped through hole; 327. first pin shaft; 328. second pin shaft; 329. flexible support plate; 330. third swing arm.

### DESCRIPTION OF EMBODIMENTS

To make the objectives, technical solutions, and advantages of this application clearer, the following further describes implementations of this application in detail with reference to the accompanying drawings.

It should be understood that "a plurality of" mentioned in this application means two or more. In the descriptions of this application, unless otherwise stated, "/" means "or". For example, A/B may indicate A or B. The term "and/or" in this specification is merely an association relationship for describing associated objects, and indicates that three relationships may exist. For example, A and/or B may indicate the following three cases: Only A exists, both A and B exist, and only B exists. In addition, to clearly describe the technical solutions of this application, words such as "first" and "second" are used to distinguish between same items or similar items with basically the same functions and effects. A person skilled in the art may understand that the words such as "first" and "second" do not limit a quantity or an execution sequence, and the words such as "first" and "second" do not indicate a definite difference.

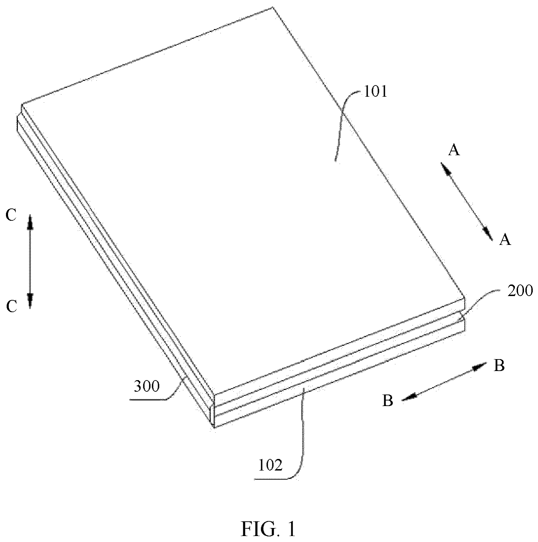

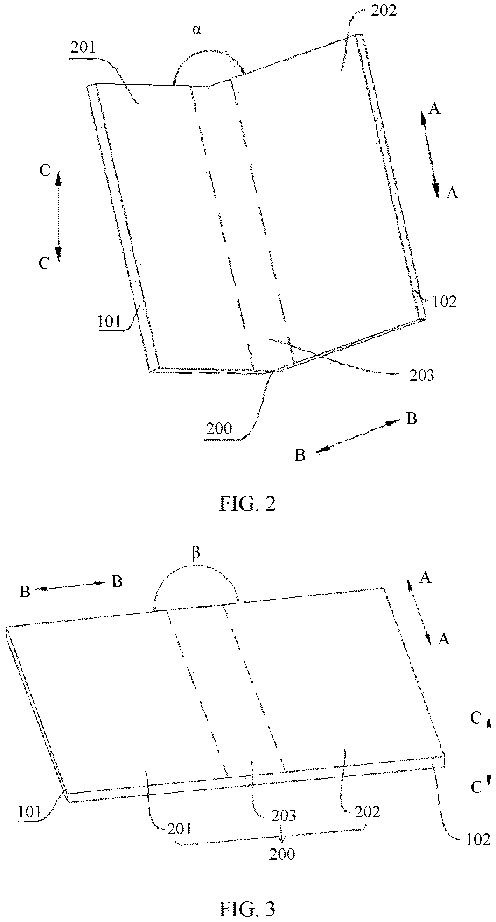

Referring to FIG. 1 to FIG. 3, FIG. 1 is a schematic diagram of a structure of an electronic device in a folded state according to an embodiment of this application, FIG. 2 is a schematic diagram of a structure of an electronic device in a half-unfolded state according to an embodiment of this application, and FIG. 3 is a schematic diagram of a structure of an electronic device in an unfolded state according to an embodiment of this application.

In one or more embodiments, this application provides an electronic device. The electronic device may be a foldable electronic device. The electronic device includes a housing and a rotating shaft mechanism 300. The housing includes a first sub-housing 101 and a second sub-housing 102. The first sub-housing 101 and the second sub-housing 102 are separately connected to the rotating shaft mechanism 300. The first sub-housing 101 and the second sub-housing 102 are capable of rotating relative to each other by using the rotating shaft mechanism 300. An example electronic device may be a mobile phone, a tablet computer, a notebook computer, or an e-reader. The foldable electronic device is not limited to an electronic device whose display screen 200 can be folded, for example, a mobile phone, and may be an electronic device whose display screen 200 and keyboard can be folded or unfolded, for example, a notebook computer.

In this embodiment of this application, in an example in which the electronic device is a mobile phone, the electronic device further includes a display screen 200, the display screen 200 may be a flexible display screen, and the display screen 200 is separately connected to the first sub-housing 101 and the second sub-housing 102. The first sub-housing 101 and the second sub-housing 102 may be middle frames of the mobile phone.

For ease of description, a width direction of the foldable electronic device is defined as a B-B direction, a length direction of the foldable electronic device is defined as an A-A direction, and a thickness direction of the foldable electronic device is defined as a C-C direction. The A-A direction, the B-B direction, and the C-C direction are perpendicular to each other.

The foldable electronic device shown in FIG. 1 is in the folded state, the foldable electronic device shown in FIG. 2 is in the half-unfolded state, and the foldable electronic device shown in FIG. 3 is in the unfolded state. An unfolding angle α of the foldable electronic device shown in FIG. 2 is 90 degrees, and an unfolding angle β of the foldable electronic device shown in FIG. 3 is 180 degrees.

It should be noted that the angle exemplified in this embodiment of this application is allowed to have a slight deviation. For example, that the unfolding angle α of the foldable electronic device shown in FIG. 2 is 90 degrees means that α may be 90 degrees, or may be approximately 90 degrees, for example, 80 degrees, 85 degrees, 95 degrees, or 100 degrees. That the unfolding angle β of the foldable electronic device shown in FIG. 3 is 180 degrees means that β may be 180 degrees, or may be approximately 180 degrees, for example, 170 degrees, 175 degrees, 185 degrees, or 190 degrees. Angles exemplified later may be understood in the same way.

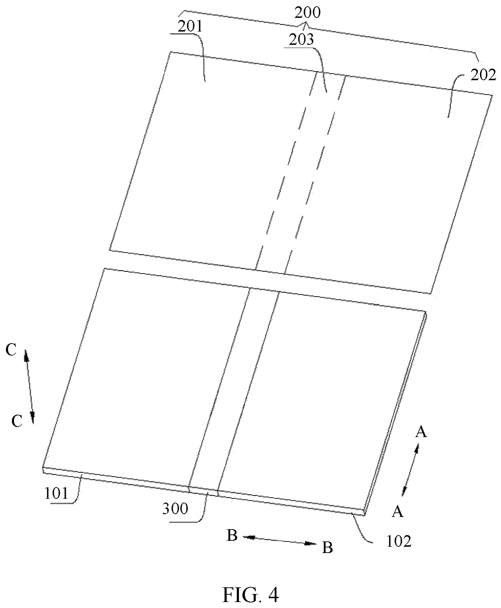

Referring to FIG. 4, FIG. 4 is a schematic diagram of an exploded structure of the electronic device shown in FIG. 3. FIG. 4 shows only a portion of the rotating shaft mechanism 300. The first sub-housing 101 and the second sub-housing 102 are respectively installed on two sides of the rotating shaft mechanism 300 in the B-B direction, and the display screen 200 includes a first portion 201, a second portion 202, and a foldable portion 203. The foldable portion 203 is located between the first portion 201 and the second portion 202, and the foldable portion 203 may be bent in the A-A direction. The first portion 201, the second portion 202, and the foldable portion 203 jointly constitute the display screen 200. In this embodiment, the display screen 200 is a flexible display screen, for example, an organic light-emitting diode (organic light-emitting diode, OLED) display screen, an active-matrix organic light-emitting diode (active-matrix organic light-emitting diode, AMOLED) display screen, a mini light-emitting diode (mini organic light emitting diode) display screen, a micro light-emitting diode (micro organic light-emitting diode) display screen, a micro organic light-emitting diode (micro organic light-emitting diode) display screen, or a quantum dot light-emitting diode (quantum dot light emitting diodes, QLED) display screen.

The first sub-housing 101 and the second sub-housing 102 approach each other to drive the display screen 200 to be folded, so that the foldable electronic device is folded. When the foldable electronic device is in the folded state, the foldable portion 203 of the display screen 200 is bent, and the first portion 201 and the second portion 202 are disposed opposite to each other. In this case, the display screen 200 is located between the first sub-housing 101 and the second sub-housing 102, so that a probability of damage to the display screen 200 can be greatly reduced, thereby effectively protecting the display screen 200.

Referring to FIG. 2 and FIG. 4 together, the first sub-housing 101 and the second sub-housing 102 rotate relative to each other by using the rotating shaft mechanism 300, and the first sub-housing 101 and the second sub-housing 102 move away from each other to drive the display screen 200 to be unfolded, so that the foldable electronic device is unfolded to the half-unfolded state. When the foldable electronic device is in the half-unfolded state, the first sub-housing 101 and the second sub-housing 102 are unfolded to the included angle α, and the first portion 201 and the second portion 202 are unfolded relative to each other and drive the foldable portion 203 to be unfolded. In this case, an included angle between the first portion 201 and the second portion 202 is α. Referring to FIG. 3 and FIG. 4 together, the first sub-housing 101 and the second sub-housing 102 rotate relative to each other by using the rotating shaft mechanism 300, and the first sub-housing 101 and the second sub-housing 102 move away from each other to drive the display screen 200 to be further unfolded until the foldable electronic device is fully unfolded. The rotating shaft mechanism 300 has a damping mechanism to implement a hand feel of opening and closing and maintain a status in a rotation process.

When the electronic device is in a fully unfolded state, an included angle between the first sub-housing 101 and the second sub-housing 102 is β. The foldable portion 203 is unfolded, and the first portion 201 and the second portion 202 are unfolded relative to each other. In this case, each of an included angle between the first portion 201 and the foldable portion 203 and an included angle the second portion 202 and the foldable portion 203 is β, and the display screen 200 has a large-area display region, to implement large-screen display of the foldable electronic device, thereby improving use experience of a user.

It should be noted that both the included angle α and the included angle β are included angles between the first sub-housing 101 and the second sub-housing 102, and are merely intended herein to distinguish between different angles between the first sub-housing 101 and the second sub-housing 102 when the foldable electronic device is in different states. The included angle α is an angle between the first sub-housing 101 and the second sub-housing 102 when the foldable electronic device is in the half-unfolded state. The included angle β is an angle between the first sub-housing 101 and the second sub-housing 102 when the foldable electronic device is in the unfolded state.

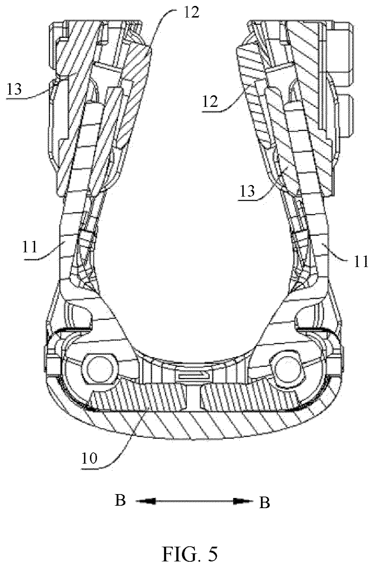

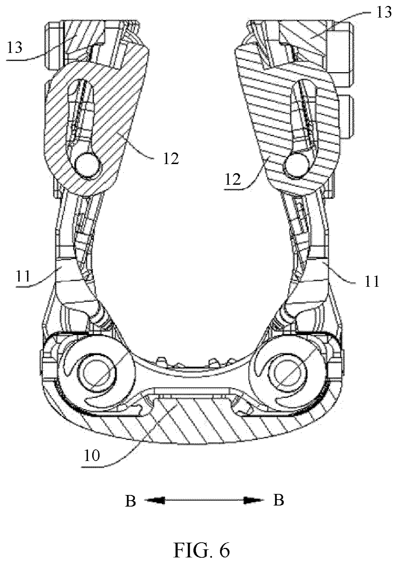

FIG. 5 and FIG. 6 are cross-sectional views of a rotating shaft mechanism in a related technology. With reference to FIG. 5 and FIG. 6, in the related technology, a foldable electronic device implements switching between a folded state and an unfolded state by using a rotating shaft mechanism. The rotating shaft mechanism includes a first base 10, a swing arm 11, a first door panel 12, and a connecting block 13. The connecting block 13 is configured to fixedly connect to a middle frame of the foldable electronic device. The swing arm 11 switches between an unfolded position and a folded position. An end of the swing arm 11 is rotatably connected to the first base 10, and the other end of the swing arm 11 is slidably connected to the connecting block 13. The connecting block 13 is rotatably connected to the first door panel 12. There is a higher-pair connection between the swing arm 11 and the first door panel 12. The first door panel 12 is driven by the swing arm 11 and the connecting block 13 together. In this way, the swing arm 11 needs to be separately kinematically connected to the first base 10, the connecting block 13, and the first door panel 12. In a use process, the foldable electronic device in the folded state may drop accidentally. During the drop, the first base 10 may first come into contact with the ground, and the first base 10 enables the swing arm 11 to slide relative to the connecting block 13. Consequently, the swing arm 11 squeezes space for accommodating a display screen, resulting an inner screen failure of the display screen.

Therefore, embodiments of this application further provide a rotating shaft mechanism 300, to resolve the foregoing problem. The following describes in detail the rotating shaft mechanism 300 provided in the embodiments of this application.

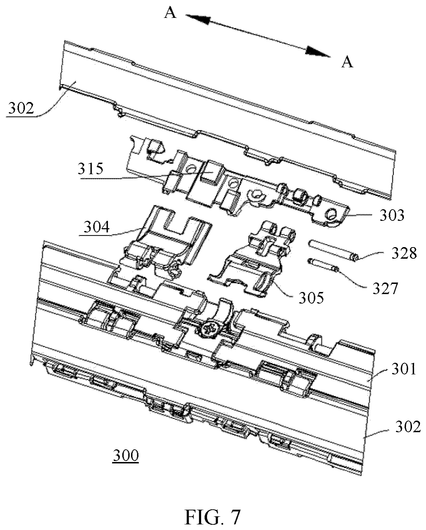

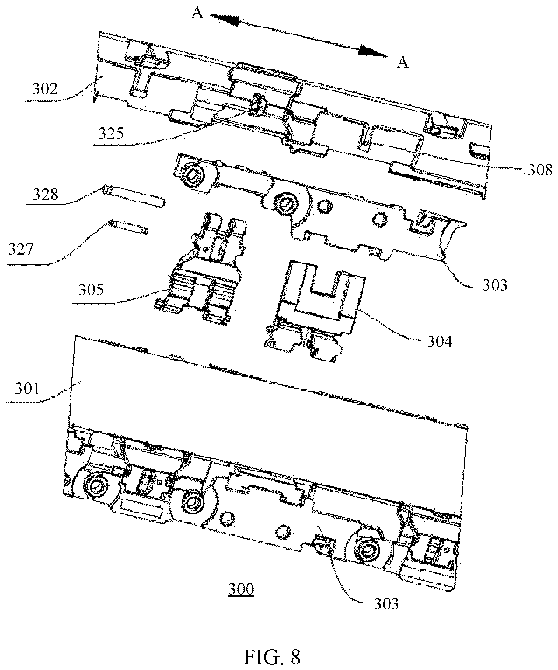

With reference to FIG. 7 to FIG. 12, in one or more embodiments, the rotating shaft mechanism 300 provided in this application includes a base 301, a door panel 302, a connecting member 303, and a first swing arm 304. The connecting member 303 is rotatably connected to the door panel 302. The first swing arm 304 is slidably connected to the connecting member 303, and the first swing arm 304 is further rotatably connected to the base 301. When the first swing arm 304 rotates from a folded position to an unfolded position relative to the base 301, the first swing arm 304 slides from a first position D to a second position E relative to the connecting member 303. There is a first limiting structure between the first swing arm 304 and the door panel 302. When the first swing arm 304 is at the folded position, the first limiting structure is capable of limiting sliding of the first swing arm 304 in a specified direction relative to the connecting member 303. The specified direction is a direction from the first position D to the second position E.

According to the rotating shaft mechanism 300 in at least one embodiment of this application, there is no direct driving relationship between the first swing arm 304 and the door panel 302. To be specific, the first swing arm 304 does not participate in driving the door panel 302, and the first swing arm 304 does not need to participate in motion of the door panel 302. When the first swing arm 304 is at the folded position, in the case of a drop, disposing the first limiting structure between the first swing arm 304 and the door panel 302 can limit sliding of the first swing arm 304 relative to the connecting member 303, which implements motion braking on the first swing arm 304, so that a possibility that the first swing arm 304 squeezes, in the case of a drop, space for accommodating a display screen 200 is reduced, thereby ensuring structural integrity and functional stability of the display screen 200, and reducing deformation occurring during the drop at the first swing arm 304. It should be noted that the rotating shaft mechanism 300 in this application is not limited to the foregoing electronic device, and may be applied to another terminal device having the rotating shaft mechanism 300.

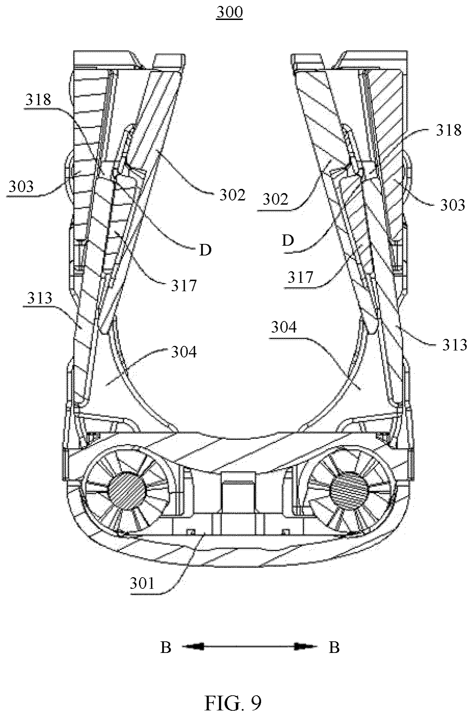

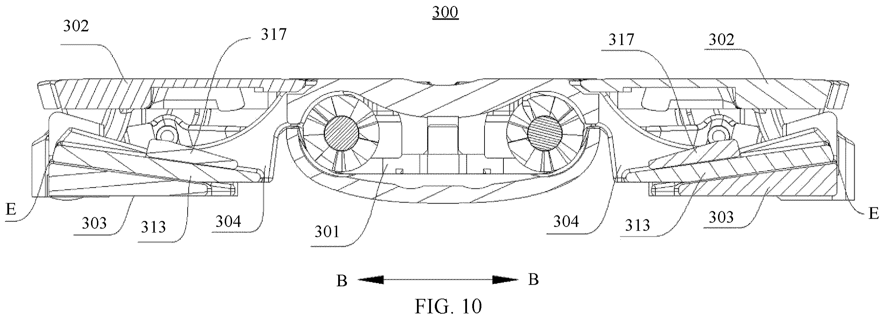

In some embodiments, when the first swing arm 304 is at the folded position relative to the base 301, the other end of the first swing arm 304 is at the first position D relative to the connecting member 303, as shown in FIG. 9. When the first swing arm 304 is at the unfolded position relative to the base 301, the other end of the first swing arm 304 is at the second position E relative to the connecting member 303, as shown in FIG. 10. The rotating shaft mechanism 300 can implement a separate connection for a first sub-housing 101 and a second sub-housing 102. Therefore, there may be a plurality of door panels 302, a plurality of connecting members 303, and a plurality of first swing arms 304 of the rotating shaft mechanism 300. For example, there are two door panels 302, and the two door panels 302 are symmetrically disposed by using a central line of the base 301 as an axis of symmetry. The central line of the base 301 is parallel to a length direction of the base 301. At least two first swing arms 304 are also symmetrically disposed by using the central line of the base 301 as an axis of symmetry. At least two connecting members 303 are symmetrically disposed by using the central line of the base 301 as an axis of symmetry. The first sub-housing 101 and the second sub-housing 102 are respectively connected to different connecting members 303. A fastening manner between the connecting member 303 and the first sub-housing 101 and between the connecting member 303 and the second sub-housing 102 may be a screw connection, or may be an integral connection such as welding. The door panel 302 is configured to support a flexible display screen, to ensure that when the foldable electronic device is in an unfolded state, the flexible display screen is supported, and flatness of the flexible display screen is maintained. One end of the first swing arm 304 is rotatably connected to the base 301, and the other opposite end of the first swing arm 304 is slidably connected to the connecting member 303. The first swing arm 304 rotates relative to the base 301 to implement status switching of the first swing arm 304 between the folded position and the unfolded position. The first limiting structure is configured to limit, when the electronic device drops, sliding of the first swing arm 304 in the specified direction relative to the connecting member 303. When the electronic device is normally used, the first limiting structure does not limit switching of the first swing arm 304 between the folded position and the unfolded position.

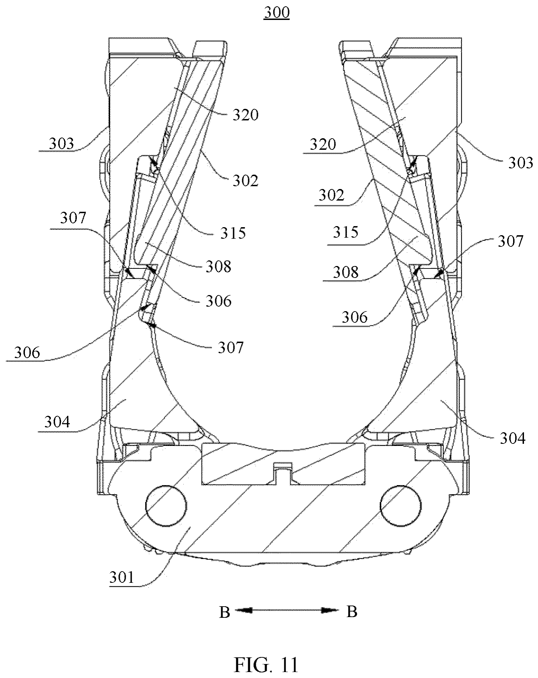

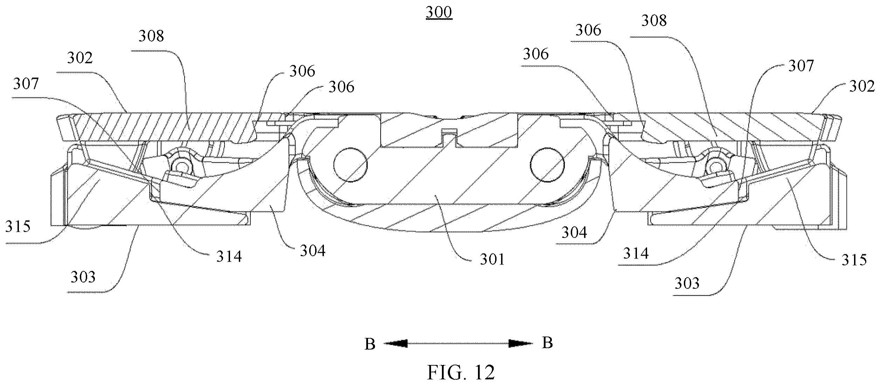

With reference to FIG. 11 and FIG. 12, in some embodiments, the first limiting structure includes a first abutment surface 306 disposed on the door panel 302 and a second abutment surface 307 disposed on the first swing arm 304, and the first abutment surface 306 is capable of being in contact with the second abutment surface 307. In this way, the first abutment surface 306 and the second abutment surface 307 are respectively disposed on the door panel 302 and the first swing arm 304. When the first swing arm 304 is at the folded position, the first abutment surface 306 can abut against the second abutment surface 307 during a drop, so that the first swing arm 304 is restricted from continuing moving relative to the connecting member 303, thereby helping ensure structural and functional integrity of the display screen 200. In addition, using a structure in which the first abutment surface 306 abuts against the second abutment surface 307 facilitates manufacturing, and the structure is relatively simple and effective.

In an embodiment, the first abutment surface 306 may be a flat surface or a curved surface, and the second abutment surface 307 may be a flat surface or a curved surface. Certainly, alternatively, a part of structure of the first abutment surface 306 may be a flat surface, and the other part thereof is a curved surface; and a part of structure of the second abutment surface 307 may be a flat surface, and the other part thereof is a curved surface. When the first swing arm 304 is at the folded position, the first abutment surface 306 may be in contact with the second abutment surface 307, or there may be a specific gap therebetween. The gap may be set based on a design requirement, or may be formed due to a manufacturing error. However, when a drop occurs, because the base 301 of the rotating shaft mechanism 300 comes into contact with the ground, the first abutment surface 306 abuts against the second abutment surface 307, to implement force transfer. Because the first swing arm 304 does not participate in driving a rotation action of the door panel 302 in a use process, the door panel 302 does not tend to rotate during the drop. Therefore, when the first abutment surface 306 on the door panel 302 comes into contact with the second abutment surface 307 on the first swing arm 304, the door panel 302 can prevent the first swing arm 304 from sliding relative to the connecting member 303, so that a possibility of squeezing space for accommodating a foldable portion 203 of the flexible display screen is reduced, thereby ensuring structural integrity and functional stability of the display screen 200, and improving safety of the flexible display screen during the drop.

In some embodiments, there are a plurality of first abutment surfaces 306, and the plurality of first abutment surfaces 306 are distributed in a stepped manner. There are a plurality of second abutment surfaces 307, and the plurality of second abutment surfaces 307 are distributed in a stepped manner.

The plurality of first abutment surfaces 306 are disposed in a one-to-one correspondence with the plurality of second abutment surfaces 307, in other words, a quantity of first abutment surfaces is equal to a quantity of second abutment surfaces. In this way, the plurality of stepped first abutment surfaces 306 one-to-one correspond to the plurality of stepped second abutment surfaces 307. In this way, after first abutment surfaces 306 at different positions abut against corresponding second abutment surfaces 307, multi-position abutment is implemented, so that effectiveness of a function of a limiting structure is ensured, thereby improving limiting and motion stop performance of the door panel 302 for the first swing arm 304. For example, as shown in FIG. 11 and FIG. 12, there are two first abutment surfaces 306 and two second abutment surfaces 307.

In an embodiment, a length direction of the door panel 302 is parallel to the length direction of the base 301, and a width direction of the door panel 302 is perpendicular to the length direction of the door panel 302. The plurality of first abutment surfaces 306 are distributed at intervals in the width direction of the door panel 302. The length direction of the base 301 is parallel to an A-A direction. The plurality of second abutment surfaces 307 are distributed at intervals in a direction from one end of the first swing arm 304 to the other opposite end of the first swing arm 304. It should be noted that when the first abutment surface 306 is a flat surface, the first abutment surface 306 may be perpendicular to the width direction of the door panel 302, or an angle formed between the first abutment surface 306 and the width direction of the door panel 302 is an acute angle, which may be specifically determined based on an actual case, provided that motion stop for the first swing arm 304 can be implemented in the case of a drop.

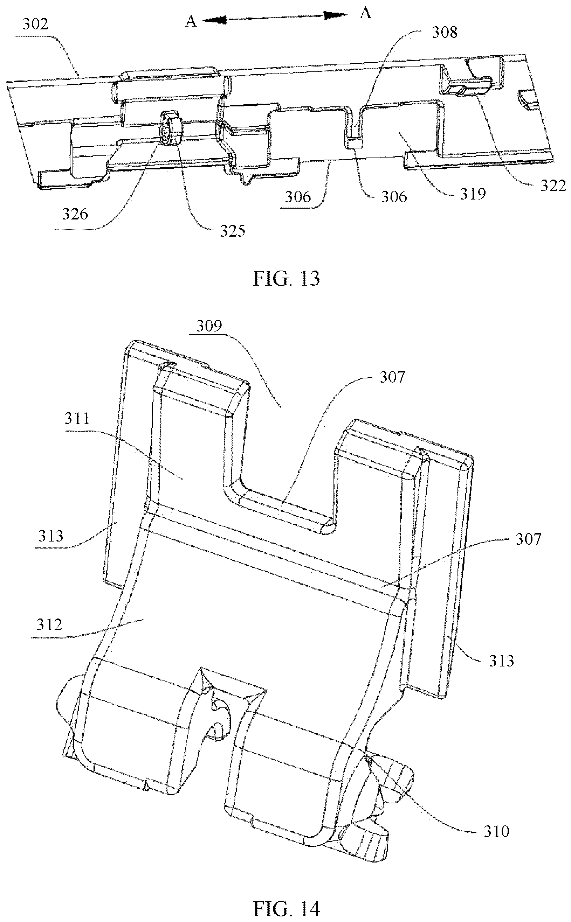

With reference to FIG. 13, FIG. 14, and FIG. 15, in some embodiments, the door panel 302 has a first protruding structure 308, and an end surface of the first protruding structure 308 forms a first abutment surface 306. The first swing arm 304 has a first recessed groove 309, and a groove wall of the first recessed groove 309 forms a second abutment surface 307. When the first swing arm 304 is at the folded position, the first protruding structure 308 extends into the first recessed groove 309, so that the first abutment surface 306 is capable of being in contact with the second abutment surface 307. After the first protruding structure 308 is inserted into the first recessed groove 309, a corresponding first abutment surface 306 and second abutment surface 307 are formed at a position at which the first protruding structure 308 abuts against the first recessed groove 309. In addition, fitting between the first protruding structure 308 and the first recessed groove 309 can optimize a fitting relationship between the door panel 302 and the first swing arm 304. The first abutment surface 306 can be in contact with the second abutment surface 307 only when the first swing arm 304 is at the folded position. In this way, motion limitation of the door panel 302 for the first swing arm 304 can be facilitated in the case of a drop, so that structural integrity and functional stability of the display screen 200 is ensured.

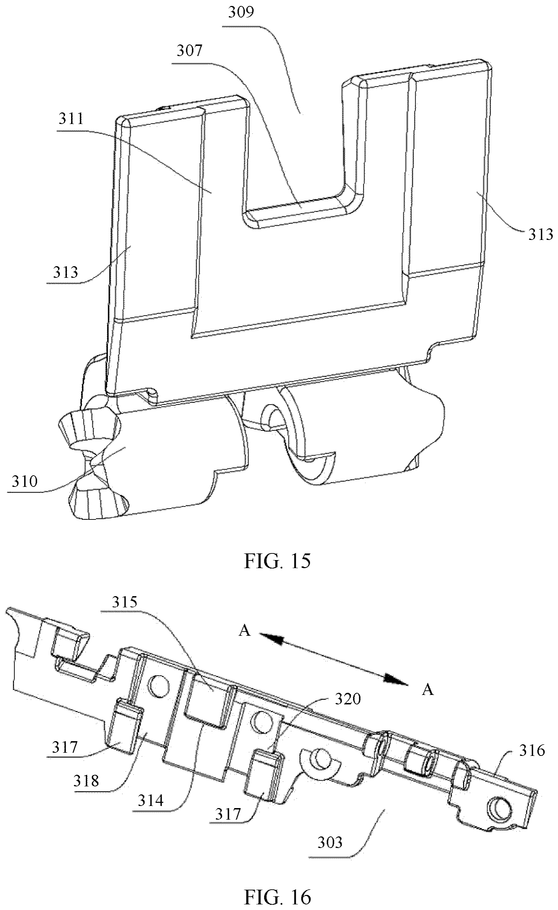

With reference to FIG. 14 and FIG. 15, in an embodiment, the first protruding structure 308 may be shaped in an elongated strip, and the first abutment surface 306 is an end surface in a length direction of the first protruding structure 308. The first recessed groove 309 is an opening groove, so that when the first swing arm 304 switches between the folded position and the unfolded position, the first protruding structure 308 can be gradually inserted into the first recessed groove 309. The first recessed groove 309 includes three groove walls, two opposite side edges of one groove wall are respectively connected to the other two groove walls, and one groove wall is disposed at an angle relative to the other two groove walls. For example, the formed angle may be an acute angle, a right angle, or a blunt angle. The one groove wall is the second abutment surface 307. When the first abutment surface 306 is in contact with the second abutment surface 307, sliding of the first swing arm 304 in the specified direction relative to the connecting member 303 can be limited. It should be noted that the first protruding structure 308 may alternatively be in another shape, provided that the first protruding structure 308 can fit with the first recessed groove 309. For example, the first protruding structure 308 may be in a cube-shaped block structure. In addition, the first protruding structure 308 may be of a linear strip-shaped structure, or may be of an arc-shaped strip structure. A structure of the first recessed groove 309 may be adapted to the first protruding structure 308. In some other possible implementations, the first recessed groove 309 may alternatively be in a form of a through hole or a blind hole.

With reference to FIG. 14 and FIG. 15, in some embodiments, the first swing arm 304 includes a first subpart 310 and a second subpart 311, the first subpart 310 is connected to the second subpart 311, a stepped surface is formed at a joint of the first subpart 310 and the second subpart 311, the stepped surface forms another second abutment surface 307, and another first abutment surface 306 is formed on a surface of an edge of the door panel 302. The first recessed groove 309 is located on the second subpart 311. The first subpart 310 of the first swing arm 304 is connected to the base 301, and the second subpart 311 is mainly configured to slidably connect to the connecting member 303. The stepped surface is formed at the joint of the first subpart 310 and the second subpart 311, the stepped surface may form the another second abutment surface 307, and the surface at the edge of the door panel 302 forms the another first abutment surface 306. In this way, after the stepped surface abuts against the surface at the edge of the door panel 302, abutment between the first abutment surface 306 and the second abutment surface 307 is implemented. In this way, in the case of a drop, the first protruding structure 308 is inserted into the first recessed groove 309, and the stepped surface abuts against the surface at the edge of the door panel 302, so that two first abutment surfaces 306 abut against two second abutment surfaces 307 in a one-to-one correspondence, thereby further ensuring structural integrity and functional stability of the display screen 200.

With reference to FIG. 14, in an embodiment, the first subpart 310 may have a curved surface structure 312. In this way, after the rotating shaft mechanism 300 is unfolded, the door panel 302 can support the flexible display screen to flatten the flexible display screen. A shape and a structure of the second subpart 311 may be set based on a requirement. For example, the shape of the second subpart 311 is designed based on a sliding manner between the first swing arm 304 and the connecting member 303. When the sliding manner between the first swing arm 304 and the connecting member 303 is linear sliding, to enable the second subpart 311 to perform linear motion relative to the connecting member 303, the second subpart 311 may be designed to be mainly formed of a flat surface structure. In this way, linear motion between the second subpart 311 and the connecting member 303 is implemented. Two opposite sides of the second subpart 311 each have a limiting plate structure 313, and the limiting plate structure 313 is in a form of a flat plate. The first recessed groove 309 is located between the two limiting plate structures 313.

It should be noted that in some other possible implementations, the sliding manner between the first swing arm 304 and the connecting member 303 may alternatively be curved surface sliding, in other words, the first swing arm 304 swings relative to the connecting member 303. The second subpart 311 is mainly formed of a curved surface structure 312, and the curved surface structure 312 may be a circular arc surface. In this way, rotation between the first swing arm 304 and the connecting member 303 is implemented through a virtual axis, in other words, rotation between the second subpart 311 and the connecting member 303 is mainly implemented through curved-surface fitting.

Returning to FIG. 11 and FIG. 12, with reference to FIG. 11 and FIG. 12, in some embodiments, there is a second limiting structure between the first swing arm 304 and the connecting member 303, and when the first swing arm 304 is at the unfolded position, the second limiting structure is capable of limiting sliding of the first swing arm 304 in the specified direction relative to the connecting member 303. In this way, the following can be implemented: The first swing arm 304 does not excessively rotate relative to the base 301, and the first swing arm 304 does not excessively slide relative to the connecting member 303. Therefore, an unfolding degree of the first swing arm 304 is limited, and excessive unfolding can be avoided. In addition, in the case of a drop, after the base 301 first comes into contact with the ground, the second limiting structure can also prevent the display screen 200 from bending in a reverse direction after a third abutment surface 314 abuts against the second abutment surface 307, so that functional stability of the display screen 200 is ensured. When the first swing arm 304 is at the unfolded position, the third abutment surface 314 may be in contact with the second abutment surface 307, or there may be a gap therebetween. The gap may be set based on a design requirement, or may be formed due to a manufacturing error. However, when a drop occurs, because the base 301 of the rotating shaft mechanism 300 comes into contact with the ground, the third abutment surface 314 can abut against the second abutment surface 307.

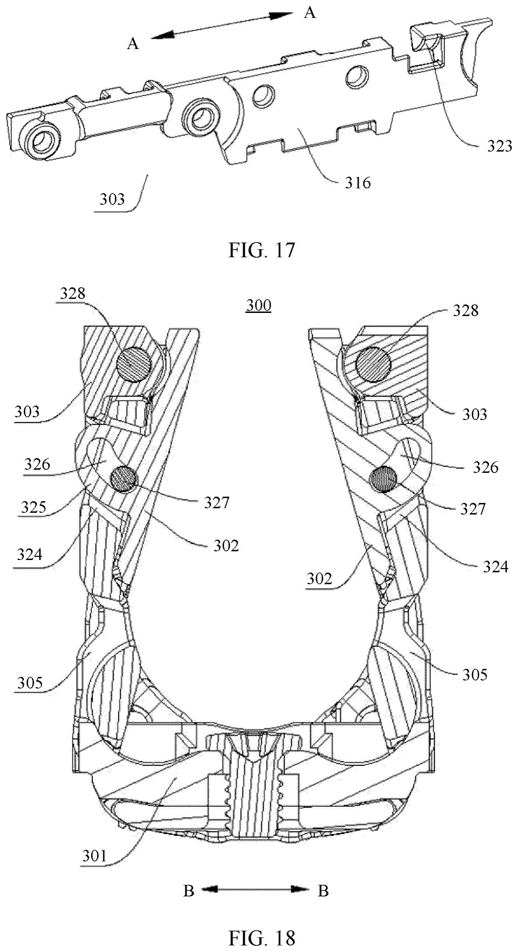

With reference to FIG. 16 and FIG. 17, in some embodiments, the second limiting structure includes the third abutment surface 314 disposed on the connecting member 303 and the second abutment surface 307 formed by the groove wall of the first recessed groove 309. The third abutment surface 314 is configured to be in contact with the second abutment surface 307. In this way, the third abutment surface 314 abuts against the second abutment surface 307, to limit an angle of rotation of the first swing arm 304 relative to the base 301. To be specific, in an unfolding process of the first swing arm 304, the unfolding degree of the first swing arm 304 is limited, and excessive unfolding can be avoided. The first abutment surface 306 and the third abutment surface 314 can respectively abut against the second abutment surface 307 in different states (a folded state and the unfolded state), so that limitation in the folded state and the unfolded state is ingeniously implemented.

It should be noted that the second limiting structure does not limit back-and-forth switching of the first swing arm 304 between the folded position and the unfolded position relative to the base 301. With reference to FIG. 16, in some embodiments, the connecting member 303 has a second protruding structure 315, and an end surface of the second protruding structure 315 forms the third abutment surface 314. When the first swing arm 304 is at the unfolded position, the second protruding structure 315 extends into the first recessed groove 309, so that the third abutment surface 314 can be in contact with the second abutment surface 307. A surface that is of the second protruding structure 315 and that abuts against the first recessed groove 309 when the second protruding structure 315 is inserted into the first recessed groove 309 is the third abutment surface 314. In this way, the first protruding structure 308 and the second protruding structure 315 are respectively inserted into the first recessed groove 309 when the first swing arm 304 is at different positions (that is, the folded position and the unfolded position), so that limitation on the first swing arm 304 relative to the connecting member 303 is implemented. In an embodiment, the second protruding structure 315 is generally cuboid-shaped.

With reference to FIG. 16, in some embodiments, the connecting member 303 includes a body part 316 and a limiting clamp arm 317, the body part 316 has a first sliding groove 318, two opposite sidewalls of the first sliding groove 318 are separately connected to the limiting clamp arm 317, and the limiting clamp arm 317 is configured to limit the first swing arm 304 within the first sliding groove 318. The door panel 302 has an avoidance groove 319, and the avoidance groove 319 is configured to accommodate the limiting clamp arm 317. A partial structure of the first swing arm 304 is located between the body part 316 and the door panel 302. The first protruding structure 308 is located in the avoidance groove 319, and the second protruding structure 315 is located in the first sliding groove 318. In this way, the first swing arm 304 is limited within the first sliding groove 318 by using the limiting clamp arm 317, so that the first swing arm 304 slides relative to the connecting member 303. However, the disposed avoidance groove 319 accommodates the limiting clamp arm 317, to implement avoidance of motion between the first swing arm 304 and the connecting member 303, and facilitate insertion of the first protruding structure 308 into the first recessed groove 309 and insertion of the second protruding structure 315 into the first recessed groove 309.

With reference to FIG. 9, FIG. 10, FIG. 14, and FIG. 16, in an embodiment, the limiting plate structure 313 is sandwiched between the limiting clamp arm 317 and a groove bottom 320 of the first sliding groove 318, so that the first swing arm 304 moves in a guide direction of the first sliding groove 318. The other end of the first swing arm 304 is a free end of the second subpart 311, a connection end of the second subpart 311 is connected to one end of the first subpart 310, and the other end of the first subpart 310 is hinged to the base 301. When the first swing arm 304 moves in a direction from the first position D to the second position E, the second subpart 311 is gradually inserted into the first sliding groove 318. When the first swing arm 304 moves in a direction from the second position E to the first position D, the second subpart 311 gradually exits the first sliding groove 318. The limiting clamp arm 317 may be mainly formed of a flat plate, and the first sliding groove 318 is in a linear form, so that linear sliding between the first swing arm 304 and the connecting member 303 is facilitated. When the first swing arm 304 is in the folded state, the first position D is a position, in the first sliding groove 318, of an end surface of the other end of the first swing arm 304. When the first swing arm 304 is in the unfolded state, the second position E is a position, in the first sliding groove 318, of an end surface of the other end of the first swing arm 304.

It should be noted that in some other possible implementations, for the sliding manner between the first swing arm 304 and the connecting member 303, different types of first sliding grooves 318 may be used based on different types of rotating shaft mechanism 300. To be specific, the first sliding groove 318 may be in a linear form, or may be in an arc surface form. When the first sliding groove 318 is in an arc surface form, the shape of the second subpart 311 needs to be adapted to a shape of the first sliding groove 318. In addition, in a same rotating shaft mechanism 300, when there are a plurality of first swing arms 304, different types of sliding grooves may be adapted to different first swing arms 304, to be specific, some first sliding grooves 318 are linear sliding grooves, and some other first sliding grooves 318 are curved-surface sliding grooves.

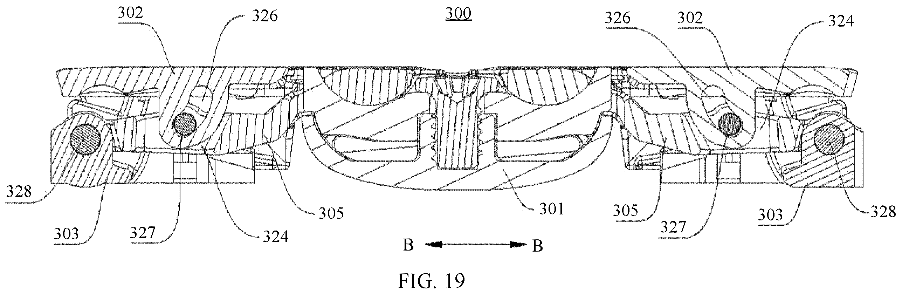

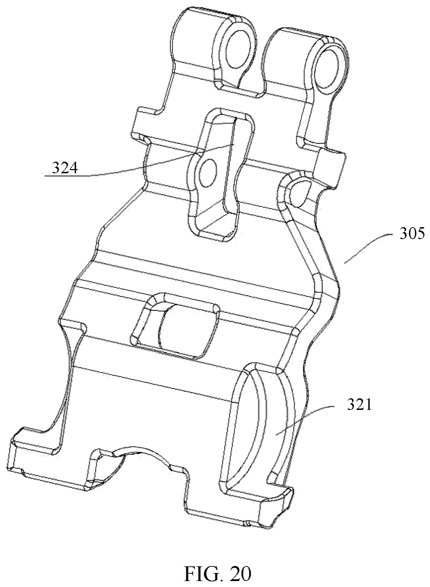

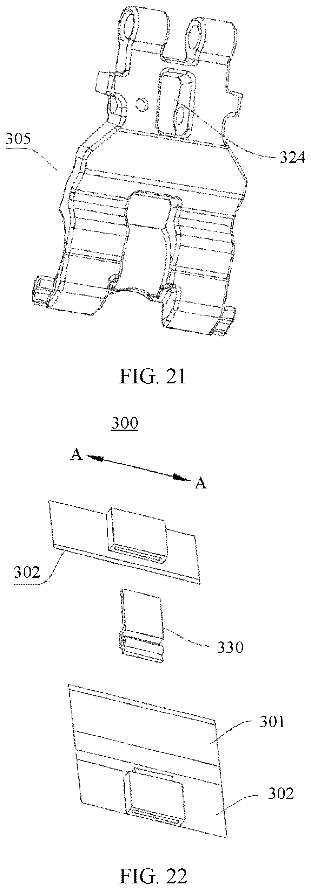

With reference to FIG. 7, FIG. 8, FIG. 18, and FIG. 19, in some embodiments, the rotating shaft mechanism 300 further includes a second swing arm 305, the second swing arm 305 is rotatably connected to the base 301, and the second swing arm 305 is rotatably connected to the connecting member 303. After the second swing arm 305 is separately rotatably connected to the base 301 and the connecting member 303, when the second swing arm 305 is at a folded position and an unfolded position relative to the base 301, a distance between an axis of the rotatable connection between the second swing arm 305 and the base 301 and an axis of the rotatable connection between the second swing arm 305 and the connecting member 303 can remain unchanged. In this case, it is ensured that the first swing arm 304 can slide relative to the connecting member 303. With reference to FIG. 20 and FIG. 21, in an embodiment, the second swing arm 305 and the base 301 are rotatably connected to each other through fitting of a circular arc surface 321, in other words, the second swing arm 305 and the base 301 are rotatably connected to each other by using a virtual axis. The second swing arm 305 and the connecting member 303 are hinged to each other by using a second pin shaft 328. There may be a plurality of second swing arms 305, and at least two second swing arms 305 are also symmetrically disposed by using the central line of the base 301 as an axis of symmetry.

It should be noted that in some other possible implementations, the second swing arm 305 and the base 301 may alternatively be hinged to each other by using a pin shaft structure.

With reference to FIG. 13 and FIG. 17, in some embodiments, there is a lower-pair connection between the door panel 302 and the connecting member 303, and the second swing arm 305 is configured to drive the door panel 302 to move. When the rotating shaft mechanism 300 switches between the folded state and the unfolded state, the door panel 302 is jointly driven by the connecting member 303 and the second swing arm 305. In addition, when the rotating shaft mechanism 300 switches between the folded state and the unfolded state, the first swing arm 304 does not participate in driving the door panel 302, in other words, there is no motion association in which the door panel 302 directly fits with the first swing arm 304. In this way, after the first limiting structure is designed between the door panel 302 and the first swing arm 304, in the case of a drop, the base 301 is first subject to a collision force, and then the force is sequentially transferred to the first swing arm 304, the door panel 302, the connecting member 303, and a housing of the electronic device, to resist relative sliding between the first swing arm 304 and a connecting block during the drop, thereby reducing a failure risk of the display screen 200.

With reference to FIG. 13 and FIG. 17, in some embodiments, a first arc surface structure 322 is disposed on the door panel 302, a second arc surface structure 323 is disposed on the connecting member 303, and the first arc surface structure 322 fits with the second arc surface structure 323. The first arc surface structure 322 fits with the second arc surface structure 323, so that the door panel 302 can rotate relative to the connecting member 303. After a higher-pair connection is used between the second swing arm 305 and the door panel 302, and a lower-pair connection is used between the door panel 302 and the connecting member 303, the door panel 302 is jointly driven by the second swing arm 305 and the connecting member 303.

With reference to FIG. 13, FIG. 18, and FIG. 20, in some embodiments, there is a higher-pair connection between the second swing arm 305 and the door panel 302, the second swing arm 305 has a first through hole 324, the door panel 302 has a first connection lug 325, the first connection lug 325 has an arc-shaped through hole 326, the first connection lug 325 is inserted into the first through hole 324, a first pin shaft 327 passes through the arc-shaped through hole 326, and the first pin shaft 327 further passes through the second swing arm 305 and is disposed on the second swing arm 305. When the second swing arm 305 rotates relative to the base 301, the first pin shaft 327 can move in an arc shape path of the arc-shaped through hole 326. In this way, driving between the second swing arm 305 and the door panel 302 is facilitated, and the door panel 302 can rotate relative to the connecting member 303.

It should be noted that in some other possible implementations, a lower-pair connection may alternatively be used between the second swing arm 305 and the door panel 302. With reference to FIG. 22, in some other possible embodiments, the rotating shaft mechanism 300 further includes a third swing arm 330. The third swing arm 330 is rotatably connected to the base 301, and the third swing arm 330 is movably connected to the door panel 302. For example, the third swing arm 330 is hinged to the base 301, and the third swing arm 330 is slidably connected to the door panel 302. When the third swing arm 330 is used, there may be no driving relationship between the second swing arm 305 and the door panel 302, and the door panel 302 may be jointly driven by the third swing arm 330 and the connecting member 303. The second swing arm 305 is not responsible for driving the door panel 302, in other words, the second swing arm 305 is rotatably connected only to the base 301 and the connecting member 303.

In some implementations, the door panel 302 is fixedly connected to the flexible display screen, and the door panel 302 may be fastened to the flexible display screen through adhesion, to implement support of the door panel 302 for the flexible display screen when the flexible display screen is unfolded. For example, the door panel 302 of the rotating shaft mechanism in FIG. 9 and FIG. 10 may be fixedly connected to the flexible display screen.

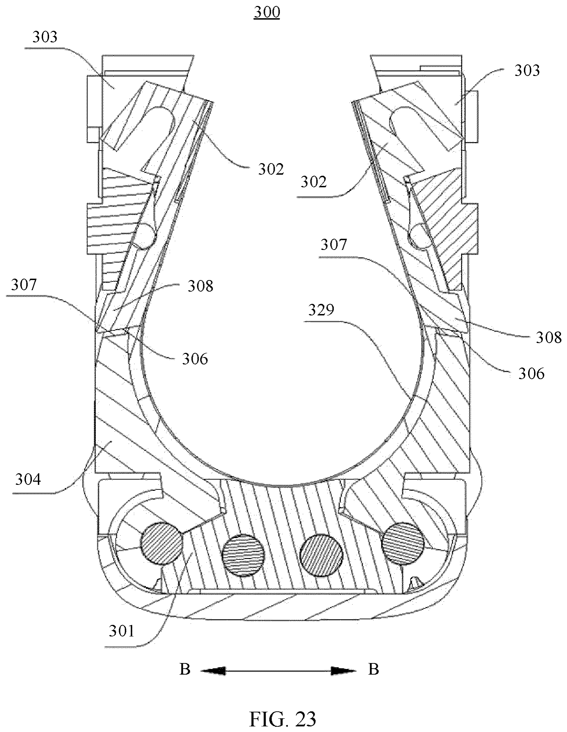

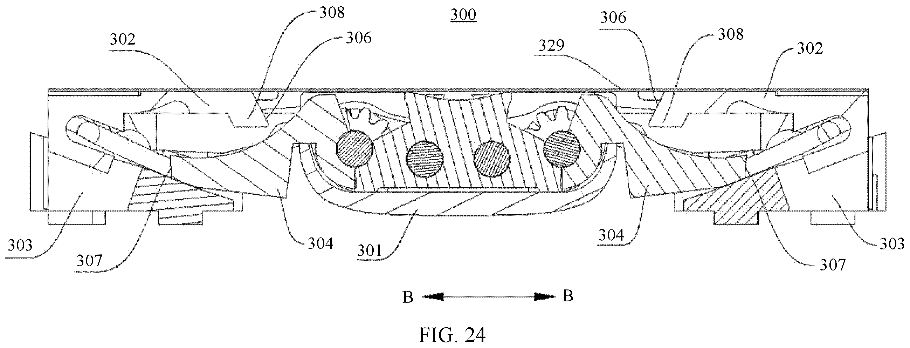

It should be noted that FIG. 23 and FIG. 24 are schematic diagrams of another variation structure of a rotating shaft mechanism. FIG. 23 and FIG. 24 show the first abutment surface 306 and the second abutment surface 307. With reference to FIG. 23 and FIG. 24, in some other possible implementations, the rotating shaft mechanism 300 further includes a flexible support plate 329, and the flexible support plate 329 is configured to support the flexible display screen of the electronic device. The flexible support plate 329 is fixedly connected to the door panel 302. The door panel 302 can move relative to the flexible display screen. A length of the door panel 302 may be equal to a width of the flexible display screen in the length direction of the base 301, or the length of the door panel 302 may be designed based on another case.

In the descriptions of the specification of this application, specific features, structures, materials, or characteristics may be properly combined in any one or more embodiments or examples.

Finally, it should be noted that the foregoing embodiments are only used to describe the technical solutions in this application, but are not used to limit this application. Although this application has been described in detail with reference to the foregoing embodiments, it should be understood by a person of ordinary skill in the art that the technical solutions described in the foregoing embodiments may still be modified, or some technical features thereof may be equivalently replaced. These modifications or replacements do not make the essence of the corresponding technical solutions depart from the spirit and scope of the technical solutions in embodiments of this application.

## Claims

1. A rotating shaft mechanism, comprising:
a base;
a door panel;
a connecting member, wherein the connecting member is rotatably connected to the door panel; and
a first swing arm, wherein the first swing arm is slidably connected to the connecting member, the first swing arm is further rotatably connected to the base, and when the first swing arm rotates from a folded position to an unfolded position relative to the base, the first swing arm slides from a first position to a second position relative to the connecting member, wherein
a first limiting structure is disposed between the first swing arm and the door panel, and when the first swing arm is at the folded position, the first limiting structure is capable of limiting sliding of the first swing arm in a specified direction relative to the connecting member, wherein the specified direction is a direction from the first position to the second position.

2. The rotating shaft mechanism according to claim 1, wherein the first limiting structure comprises a first abutment surface disposed on the door panel and a second abutment surface disposed on the first swing arm, and the first abutment surface is capable of being in contact with the second abutment surface.

3. The rotating shaft mechanism according to claim 2, wherein a plurality of the first abutment surfaces are distributed in a stepped manner;
a plurality of the second abutment surfaces are distributed in a stepped manner; and
the plurality of first abutment surfaces are in a one-to-one correspondence with the plurality of second abutment surfaces.

4. The rotating shaft mechanism according to claim 2, wherein the door panel has a first protruding structure, and an end surface of the first protruding structure forms a first abutment surface;
the first swing arm has a first recessed groove, and a groove wall of the first recessed groove forms a second abutment surface; and
when the first swing arm is at the folded position, the first protruding structure extends into the first recessed groove, so that the first abutment surface is capable of being in contact with the second abutment surface.

5. The rotating shaft mechanism according to claim 4, wherein the first swing arm comprises a first subpart and a second subpart, the first subpart is connected to the second subpart, a stepped surface is formed at a joint of the first subpart and the second subpart, the stepped surface forms another second abutment surface, and a surface at an edge of the door panel forms another first abutment surface; and the first recessed groove is located on the second subpart.

6. The rotating shaft mechanism according to claim 4, wherein a second limiting structure is disposed between the first swing arm and the connecting member, and when the first swing arm is at the unfolded position, the second limiting structure is capable of limiting sliding of the first swing arm in the specified direction relative to the connecting member.

7. The rotating shaft mechanism according to claim 6, wherein the second limiting structure comprises a third abutment surface disposed on the connecting member and the second abutment surface formed by the groove wall of the first recessed groove; and
the third abutment surface is configured to be in contact with the second abutment surface.

8. The rotating shaft mechanism according to claim 7, wherein the connecting member has a second protruding structure, and an end surface of the second protruding structure forms the third abutment surface; and
when the first swing arm is at the unfolded position, the second protruding structure extends into the first recessed groove, so that the third abutment surface is capable of being in contact with the second abutment surface.

9. The rotating shaft mechanism according to claim 8, wherein the connecting member comprises a body part and a limiting clamp arm, the body part has a first sliding groove, two opposite sidewalls of the first sliding groove are separately connected to the limiting clamp arm, and the limiting clamp arm is configured to limit the first swing arm within the first sliding groove;
the door panel has an avoidance groove, and the avoidance groove is configured to accommodate the limiting clamp arm;
a partial structure of the first swing arm is located between the body part and the door panel; and
the first protruding structure is located in the avoidance groove, and the second protruding structure is located in the first sliding groove.

10. The rotating shaft mechanism according to claim 9, wherein the first sliding groove is a linear sliding groove, and is configured to enable the first swing arm to linearly move relative to the connecting member; or
the first sliding groove is a curved-surface sliding groove, and is configured to enable the first swing arm to swing relative to the connecting member.

11. The rotating shaft mechanism according to any one of claims 1-10, wherein the rotating shaft mechanism further comprises a second swing arm, the second swing arm is rotatably connected to the base, and the second swing arm is rotatably connected to the connecting member.

12. The rotating shaft mechanism according to claim 11, wherein a lower-pair connection is disposed between the door panel and the connecting member, and the second swing arm is configured to drive the door panel to move.

13. The rotating shaft mechanism according to claim 12, wherein a higher-pair connection is disposed between the second swing arm and the door panel, the second swing arm has a first through hole, the door panel has a first connection lug, the first connection lug has an arc-shaped through hole, the first connection lug is inserted into the first through hole, a first pin shaft passes through the arc-shaped through hole, and the first pin shaft further passes through the second swing arm and is disposed on the second swing arm.

14. The rotating shaft mechanism according to claim 12, wherein a first arc surface structure is disposed on the door panel, a second arc surface structure is disposed on the connecting member, and the first arc surface structure fits with the second arc surface structure.

15. The rotating shaft mechanism according to claim 11, wherein the rotating shaft mechanism further comprises a third swing arm, the third swing arm is rotatably connected to the base, and the third swing arm is movably connected to the door panel.

16. The rotating shaft mechanism according to any one of claims 1-10, wherein the rotating shaft mechanism further comprises a flexible support plate, and the flexible support plate is configured to support a flexible display screen of an electronic device; and the flexible support plate is fixedly connected to the door panel.

17. A rotating shaft mechanism, comprising:
a base;
a door panel;
a connecting member, wherein the connecting member is rotatably connected to the door panel; and
a first swing arm, wherein the first swing arm is slidably connected to the connecting member, the first swing arm is further rotatably connected to the base, and when the first swing arm rotates from a folded position to an unfolded position relative to the base, the first swing arm slides from a first position to a second position relative to the connecting member, wherein
a first limiting structure is disposed between the first swing arm and the door panel, and when the first swing arm is at the folded position, the first limiting structure is capable of limiting sliding of the first swing arm in a specified direction relative to the connecting member, wherein the specified direction is a direction from the first position to the second position; and
the first limiting structure comprises a first abutment surface disposed on the door panel and a second abutment surface fastened on the first swing arm, and the first abutment surface is capable of being in contact with the second abutment surface.

18. The rotating shaft mechanism according to claim 17, wherein a plurality of the first abutment surfaces are distributed in a stepped manner;
a plurality of the second abutment surfaces are distributed in a stepped manner; and
the plurality of first abutment surfaces are in a one-to-one correspondence with the plurality of second abutment surfaces.

19. The rotating shaft mechanism according to claim 17, wherein the door panel has a first protruding structure, and an end surface of the first protruding structure forms a first abutment surface;
the first swing arm has a first recessed groove, and a groove wall of the first recessed groove forms a second abutment surface; and
when the first swing arm is at the folded position, the first protruding structure extends into the first recessed groove, so that the first abutment surface is capable of being in contact with the second abutment surface.

20. The rotating shaft mechanism according to claim 19, wherein the first swing arm comprises a first subpart and a second subpart, the first subpart is connected to the second subpart, a stepped surface is formed at a joint of the first subpart and the second subpart, the stepped surface forms another second abutment surface, and a surface at an edge of the door panel forms another first abutment surface; and the first recessed groove is located on the second subpart.

21. The rotating shaft mechanism according to claim 19, wherein a second limiting structure is disposed between the first swing arm and the connecting member, and when the first swing arm is at the unfolded position, the second limiting structure is capable of limiting sliding of the first swing arm in the specified direction relative to the connecting member.

22. The rotating shaft mechanism according to claim 21, wherein the second limiting structure comprises a third abutment surface disposed on the connecting member and the second abutment surface formed by the groove wall of the first recessed groove; and
the third abutment surface is configured to be in contact with the second abutment surface.

23. The rotating shaft mechanism according to claim 22, wherein the connecting member has a second protruding structure, and an end surface of the second protruding structure forms the third abutment surface; and
when the first swing arm is at the unfolded position, the second protruding structure extends into the first recessed groove, so that the third abutment surface is capable of being in contact with the second abutment surface.

24. The rotating shaft mechanism according to claim 23, wherein the connecting member comprises a body part and a limiting clamp arm, the body part has a first sliding groove, two opposite sidewalls of the first sliding groove are separately connected to the limiting clamp arm, and the limiting clamp arm is configured to limit the first swing arm within the first sliding groove;
the door panel has an avoidance groove, and the avoidance groove is configured to accommodate the limiting clamp arm;
a partial structure of the first swing arm is located between the body part and the door panel; and
the first protruding structure is located in the avoidance groove, and the second protruding structure is located in the first sliding groove.

25. The rotating shaft mechanism according to claim 24, wherein the first sliding groove is a linear sliding groove, and is configured to enable the first swing arm to linearly move relative to the connecting member; or
the first sliding groove is a curved-surface sliding groove, and is configured to enable the first swing arm to swing relative to the connecting member.

26. The rotating shaft mechanism according to any one of claims 17-25, wherein the rotating shaft mechanism further comprises a second swing arm, the second swing arm is rotatably connected to the base, and the second swing arm is rotatably connected to the connecting member.

27. The rotating shaft mechanism according to claim 26, wherein a lower-pair connection is disposed between the door panel and the connecting member, and the second swing arm is configured to drive the door panel to move.

28. The rotating shaft mechanism according to claim 27, wherein a higher-pair connection is disposed between the second swing arm and the door panel, the second swing arm has a first through hole, the door panel has a first connection lug, the first connection lug has an arc-shaped through hole, the first connection lug is inserted into the first through hole, a first pin shaft passes through the arc-shaped through hole, and the first pin shaft further passes through the second swing arm and is disposed on the second swing arm.

29. The rotating shaft mechanism according to claim 27, wherein a first arc surface structure is disposed on the door panel, a second arc surface structure is disposed on the connecting member, and the first arc surface structure fits with the second arc surface structure.

30. The rotating shaft mechanism according to claim 26, wherein the rotating shaft mechanism further comprises a third swing arm, the third swing arm is rotatably connected to the base, and the third swing arm is movably connected to the door panel.

31. The rotating shaft mechanism according to any one of claims 17-25, wherein the rotating shaft mechanism further comprises a flexible support plate, and the flexible support plate is configured to support a flexible display screen of an electronic device; and the flexible support plate is fixedly connected to the door panel.

32. An electronic device, comprising a flexible display screen, a housing, and the rotating shaft mechanism according to any one of claims 1-31, wherein the housing comprises a first sub-housing and a second sub-housing, the first sub-housing and the second sub-housing are separately connected to the rotating shaft mechanism, and the first sub-housing and the second sub-housing are capable of rotating relative to each other by using the rotating shaft mechanism; and the flexible display screen is separately connected to the first sub-housing and the second sub-housing.

33. The electronic device according to claim 32, wherein the door panel is fixedly connected to the flexible display screen; or
the door panel is capable of moving relative to the flexible display screen.
